(19) 

Europäisches
Patentamt
European
Patent Office
Office européen
des brevets

(11) **EP 4 450 986 A1**

(12) **EUROPEAN PATENT APPLICATION**
published in accordance with Art. 153(4) EPC

(43) Date of publication:
**23.10.2024 Bulletin 2024/43**

(21) Application number: **21969340.5**

(22) Date of filing: **28.12.2021**

(51) International Patent Classification (IPC):
*G01R 31/36* (2020.01)   *G01R 31/367* (2019.01)
*G01R 31/392* (2019.01)   *H01M 10/48* (2006.01)

(52) Cooperative Patent Classification (CPC):
**G01R 31/36; G01R 31/367; G01R 31/392;
H01M 10/48**

(86) International application number:
**PCT/CN2021/142096**

(87) International publication number:
**WO 2023/122961 (06.07.2023 Gazette 2023/27)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Contemporary Amperex Technology
(Hong Kong) Limited
Central, Central And Western District (HK)**

(72) Inventor: **ZUO, Xiyang
Ningde, Fujian 352100 (CN)**

(74) Representative: **Gong, Jinping
CocreateIP
Neumarkterstr. 21
81673 München (DE)**

(54) **STATE CALIBRATION METHOD AND APPARATUS FOR LOW-VOLTAGE BATTERY, AND
ELECTRIC VEHICLE**

(57) This application provides a state calibration method and apparatus for a low-voltage battery, and an electric vehicle. The low-voltage battery includes at least one cell. The method includes controlling the low-voltage battery to discharge at a first discharge rate until voltage of at least one cell in the low-voltage battery is not greater than a first voltage threshold; controlling the low-voltage battery to charge at a first charge rate until voltage of at least one cell in the low-voltage battery is not less than a second voltage threshold; obtaining a quantity of charge charged into the low-voltage battery; and obtaining a state of health value of each cell based on the quantity of charge charged into the low-voltage battery and calibrating a state of health value of the low-voltage battery based on the state of health value of each cell. With this method, the detection accuracy of SOH can be improved.

Control a low-voltage battery to discharge at a first discharge rate until voltage of at least one cell in the low-voltage battery is not greater than a first voltage threshold — 21

Control the low-voltage battery to charge at a first charge rate until voltage of at least one cell in the low-voltage battery is not less than a second voltage threshold — 22

Obtain a quantity of charge charged into the low-voltage battery — 23

Obtain a state of health value of each cell based on the quantity of charge charged into the low-voltage battery and calibrate a state of health value of the low-voltage battery based on the state of health value of each cell — 24

FIG. 2

## Description

## TECHNICAL FIELD

This application relates to the field of battery technologies, and in particular, to a state calibration method and apparatus for a low-voltage battery, and an electric vehicle.

## BACKGROUND

With the increasingly severe energy and environmental issues, the stronger support for new energy by the government, and the maturing of power battery technology, electric vehicles have become a new direction for the future development of the automotive industry. The cruising range of electric vehicles has become an important factor affecting their widespread adoption. As a key component, the battery serves as a principal energy source for electric vehicles, and the stability and reliability of battery products are of utmost importance. Batteries encompass both low-voltage and high-voltage types.

For low-voltage batteries, current technologies typically rely on a battery management system (Battery Management System, BMS) to directly capture cell conditions, such as voltage and temperature, to calculate the state of health (State of Health, SOH) of the low-voltage battery.

However, due to the intricate operational environments and the high rates of charging and discharging associated with low-voltage batteries and other environmental factors, the accuracy of SOH detection in existing methods is comparatively low.

## SUMMARY

This application aims to provide a state calibration method and apparatus for a low-voltage battery, and an electric vehicle, able to improve the detection accuracy of SOH.

To achieve the above objectives, according to a first aspect, this application provides a state calibration method for a low-voltage battery, where the low-voltage battery includes at least one cell. The method includes controlling the low-voltage battery to discharge at a first discharge rate until voltage of at least one cell in the low-voltage battery is not greater than a first voltage threshold; controlling the low-voltage battery to charge at a first charge rate until voltage of at least one cell in the low-voltage battery is not less than a second voltage threshold; obtaining a quantity of charge charged into the low-voltage battery; and obtaining a state of health value of each cell based on the quantity of charge charged into the low-voltage battery and calibrating a state of health value of the low-voltage battery based on the state of health value of each cell.

Firstly, in this method, the charging and discharging process of the low-voltage battery is controlled so as to obtain the SOH value of each cell based on the quantity of charge charged and finally determine the current SOH value of the low-voltage battery based on the SOH value of each cell, thereby obtaining a comparatively accurate SOH value. Furthermore, with the first and second voltage thresholds specified, full charging and full discharging of cells can be realized, and the SOH value of the low-voltage battery can be calibrated in the process, thus obtaining a more accurate SOH value, which is beneficial for providing more energy to a low-voltage load through the low-voltage battery. Moreover, with a more accurate SOH value obtained, the power output of the low-voltage battery can be controlled more accurately, thereby effectively reducing the risk of battery damage, which is beneficial to improving the stability of battery performance and extending the battery life.

In an optional manner, before the controlling the low-voltage battery to charge at a first discharge rate, the method further includes: within a first duration, controlling the low-voltage battery to be in an idle state.

With the low-voltage battery placed in an idle state, the polarization phenomenon of the low-voltage battery can be eliminated, stabilizing the state of the low-voltage battery. Thus, more reliable data can be obtained, which is beneficial for improving the accuracy of calculating the battery's state of health value.

In an optional manner, the obtaining a state of health value of each cell based on the quantity of charge charged into the low-voltage battery includes: obtaining a pre-calibration rated capacity of the cell; and calculating a ratio of the quantity of charge charged into the low-voltage battery to the pre-calibration rated capacity of the cell to obtain the state of health value of each cell.

With the state of health value of each cell obtained, the overall actual state of health value of the battery can be more accurately reflected, making a small deviation between the calculated state of health value of the battery and the actual state of health value of the battery, thus obtaining a comparatively accurate state of health value.

In an optional manner, the calibrating a state of health value of the low-voltage battery based on the state of health value of each cell includes: taking a smallest value among the state of health value of each cell as a current state of health value of the low-voltage battery.

With the smallest value taken as the current state of health value of the low-voltage battery, it can be ensured that there is enough energy available for release. In other words, this can increase the usable capacity of the battery, making full use of the battery's performance. Furthermore, it also ensures a certain residual capacity to prevent the battery from over-discharging, thus protecting the battery and extending its service life.

In an optional manner, the low-voltage battery is provided in an electric vehicle, and before the controlling the low-voltage battery to discharge at a first discharge rate, the method further includes: in an event that the electric vehicle is in an idle condition, obtaining a second duration based on an SOC value of the low-voltage battery, where the second duration is a duration for calibrating the state of the low-voltage battery; and the SOC value is a ratio of a remaining quantity of charge of the battery to a nominal capacity of the battery.

Before calibration, it is first necessary to place the electric vehicle in an idle condition to ensure that the low-voltage battery executes the state calibration process without interference from external conditions, enhancing the accuracy of calibration. Then, after it is determined that the electric vehicle is in an idle condition, the duration required for the entire process of calibrating the state of the low-voltage battery can be determined based on the SOC value of the low-voltage battery, better managing the subsequent calibration process.

In an optional manner, the method further includes: displaying the second duration through the electric vehicle.

With the second duration displayed through the electric vehicle, a reminder can be provided to a user of the electric vehicle. Then, after being informed of the time required for the state calibration of the low-voltage battery, the user can arrange the use and calibration time of the electric vehicle according to the user's actual situation, bringing convenience to the user and enhancing user experience.

In an optional manner, the method further includes: on an occasion that the second duration is not displayed through the electric vehicle, determining calibration of the low-voltage battery as a failure in an event that the calibration of the low-voltage battery is not completed within the second duration.

On occasions that the second duration is not displayed through the electric vehicle, if situations such as the user starting the vehicle occur within the second duration, causing the calibration of the low-voltage battery to be incomplete, then, the calibration of the low-voltage battery should be determined as a failure. Thus, the likelihood of mis-calibration can be reduced, making the subsequent calibration results more reliable.

In an optional manner, the electric vehicle further includes a high-voltage battery, a bidirectional DC/DC module, and a low-voltage load. The high-voltage battery is connected to the low-voltage battery through the bidirectional DC/DC module, and the low-voltage battery is connected to the low-voltage load. The controlling the low-voltage battery to discharge at a first discharge rate includes: controlling the bidirectional DC/DC module to control the low-voltage battery to discharge to the high-voltage battery at the first discharge rate.

In an optional manner, the controlling the low-voltage battery to charge at a first charge rate includes: controlling the bidirectional DC/DC module to control the high-voltage battery to charge the low-voltage battery at the first charge rate.

Through use of the bidirectional DC/DC module, charging and discharging processes can be realized between the high-voltage battery and the low-voltage battery. Then, conditions can be created for the full charging and full discharging of the low-voltage battery. If the state of the low-voltage battery is adjusted during full charging and full discharging of the low-voltage battery, a more accurate SOH value can be obtained, which is beneficial for providing more energy to the low-voltage load through the low-voltage battery.

According to a second aspect, this application provides a state calibration apparatus for a low-voltage battery, where the low-voltage battery includes at least one cell. The apparatus includes a discharge control unit, a charge control unit, a charge quantity acquisition unit, and a state calibration unit. The discharge control unit is configured to control the low-voltage battery to discharge at a first discharge rate until voltage of at least one cell in the low-voltage battery is not greater than a first voltage threshold. The charge control unit is configured to control the low-voltage battery to charge at a first charge rate until voltage of at least one cell in the low-voltage battery is not less than a second voltage threshold. The charge quantity acquisition unit is configured to obtain a quantity of charge charged into the low-voltage battery. The state calibration unit is configured to obtain a state of health value of each cell based on the quantity of charge charged into the low-voltage battery and calibrate a state of health value of the low-voltage battery based on the state of health value of each cell.

According to a third aspect, this application provides a main control unit including a memory and a processor coupled to the memory, where the processor is configured to execute instructions stored in the memory to perform the method as described in the first aspect.

According to a fourth aspect, this application provides an electric vehicle including a low-voltage battery and the main control unit as described in the third aspect, where the main control unit is configured to calibrate state of the low-voltage battery.

In an optional manner, the electric vehicle further includes a high-voltage battery and a bidirectional DC/DC module. The high-voltage battery is connected to the low-voltage battery through the bidirectional DC/DC module, and the bidirectional DC/DC module is connected to the main control unit. The main control unit is configured to control the bidirectional DC/DC module, so that the high-voltage battery charges the low-voltage battery, or the low-voltage battery charges the high-voltage battery.

In an optional manner, the main control unit includes a vehicle controller, a low-voltage battery control unit, a logic control unit for the bidirectional DC/DC module, and a high-voltage battery control unit. The vehicle controller is configured to control the low-voltage battery control unit, the logic control unit for the bidirectional DC/DC module, and the high-voltage battery control unit. The low-voltage battery control unit is configured to control charging and discharging of the low-voltage battery.

The logic control unit for the bidirectional DC/DC module is configured to control the bidirectional DC/DC module. The high-voltage battery control unit is configured to control charging and discharging of the high-voltage battery.

According to a fifth aspect, this application provides a computer-readable storage medium including computer-executable instructions, where the computer-executable instructions are set as a process of the method as described in the first aspect.

Embodiments of this application provide the following beneficial effect: The state calibration method for a low-voltage battery provided by this application includes controlling the low-voltage battery to discharge at a first discharge rate until voltage of at least one cell in the low-voltage battery is not greater than a first voltage threshold; controlling the low-voltage battery to charge at a first charge rate until voltage of at least one cell in the low-voltage battery is not less than a second voltage threshold; obtaining a quantity of charge charged into the low-voltage battery; and obtaining a state of health value of each cell based on the quantity of charge charged into the low-voltage battery and calibrating a state of health value of the low-voltage battery based on the state of health value of each cell. In this method, the charging and discharging process of the low-voltage battery is controlled so that the SOH value of each cell can be obtained based on the quantity of charge charged, and the current SOH value of the low-voltage battery can be finally determined based on the SOH value of each cell, thereby obtaining a comparatively accurate SOH value. Furthermore, with the first and second voltage thresholds specified, full charging and full discharging of cells can be realized, and the SOH value of the low-voltage battery can be calibrated in the process, thus obtaining a more accurate SOH value, which is beneficial for providing more energy to the low-voltage load through the low-voltage battery. Moreover, after a more accurate SOH value is obtained, the power output of the low-voltage battery can be controlled more accurately, thereby effectively reducing the risk of battery damage, which is beneficial to improving the stability of battery performance and extending the battery life.

## BRIEF DESCRIPTION OF DRAWINGS

To more clearly illustrate the technical solutions in the embodiments of this application, the drawings needed for the embodiments are briefly introduced below. Obviously, the drawings described below are only some embodiments of this application, and for persons skilled in the art, other drawings can be obtained based on these drawings without creative efforts.

FIG. 1 is a schematic structural diagram of an electric vehicle disclosed in an embodiment of this application;
FIG. 2 is a flowchart of a state calibration method for a low-voltage battery disclosed in an embodiment of this application;
FIG. 3 is a schematic diagram of an implementation of step 24 shown in FIG. 2 disclosed in an embodiment of this application;
FIG. 4 is a flowchart of a state calibration method for a low-voltage battery disclosed in another embodiment of this application;
FIG. 5 is a schematic structural diagram of a state calibration apparatus for a low-voltage battery disclosed in an embodiment of this application; and
FIG. 6 is a schematic structural diagram of a main control unit disclosed in an embodiment of this application.

In the drawings, the drawings are not drawn to actual scale.

## DESCRIPTION OF EMBODIMENTS

Embodiments of this application will be further described in detail below with reference to the drawings and example implementations. The following detailed description of embodiments and the drawings are used to exemplify the principles of this application but are not intended to limit the scope of this application, that is, this application is not limited to the described embodiments.

In the description of this application, it should be noted that unless otherwise specified, "a plurality of" means two or more; the terms "upper", "lower", "left", "right", "inner", "outer", and the like indicate orientations or positional relationships only for the convenience of describing this application and simplifying the description, and do not indicate or imply that the means or elements referred to must have a specific orientation or be constructed and operated in a specific orientation, and therefore, they should not be construed as limiting this application. In addition, the terms "first", "second", "third", and the like are only for descriptive purposes and cannot be understood as indicating or implying relative importance. "Perpendicular" is not strictly perpendicular, but within an allowable error range. "Parallel" is not strictly parallel, but within an allowable error range.

The orientation words appearing in the following description are all directions as shown in the drawings and are not intended to limit the specific structure of this application. In the description of this application, it should also be noted that unless otherwise explicitly specified and defined, the terms "install", "connect", and "join" should be understood in a broad sense. For example, they may refer to a fixed connection, a detachable connection, or an integral connection; and may refer to a direct connection or an indirect connection through an intermediate medium. For persons skilled in the art, the specific meanings of the above terms in this application can be understood as appropriate to specific situations.

In recent years, the new energy vehicle industry has experienced explosive growth. The battery is the core of electric vehicles and is a comprehensive embodiment of automotive engineering and electrical engineering technology. Batteries encompass both low-voltage and high-voltage types. In low-voltage batteries, it is usually necessary to detect their SOH values to determine the current performance state of the low-voltage battery. Therefore, how to accurately detect the SOH value of the low-voltage battery is particularly important.

The inventor of this application, in the process of implementing this application, found that: the current common method of calculating the SOH value of a low-voltage battery is: using a BMS to capture cell conditions such as voltage and temperature to calculate the SOH value of the voltage battery.

However, due to the intricate operational environments and the high rates of charging and discharging associated with low-voltage batteries and other environmental factors, the calculated SOH value may deviate significantly from the actual SOH value. That is, the accuracy of the calculated SOH value is poor, thus failing to reflect the true situation of the SOH value of the low-voltage battery.

Given this, the applicant designed a state calibration method for a low-voltage battery. This method, by controlling the charging and discharging process of the low-voltage battery, obtains the SOH value of each cell based on the quantity of charge charged, and finally determines the current SOH value of the low-voltage battery based on the SOH value of each cell, thus obtaining a comparatively accurate SOH value. Then, with a comparatively accurate SOH value obtained in real-time, the performance of cells can be fully utilized and the service life of the battery is extended.

The battery including cells disclosed in the embodiments of this application can be used in electric devices such as vehicles, ships, or aircraft. A power system composed of cells and batteries disclosed in this application can be used in these electric devices, so that, the power output of the battery can be controlled based on the detected SOH value of the battery, effectively reducing the risk of battery damage, which is beneficial for enhancing the stability of battery performance and extending the battery's service life.

An embodiment of this application provides an electric device using a battery as a power source, where the battery includes at least one cell. The electric device can be but is not limited to mobile phones, tablets, laptops, electric toys, electric tools, electric bicycles, electric vehicles, ships, spacecraft, and so on. Among them, electric toys may include fixed or mobile electric toys, such as game consoles, electric toy cars, electric toy ships, and electric toy airplanes, and spacecraft may include airplanes, rockets, space shuttles, spaceships, and the like.

For convenience of explanation, the following embodiments are described using the electric device of an embodiment of this application being a capacitor vehicle 10 as an example.

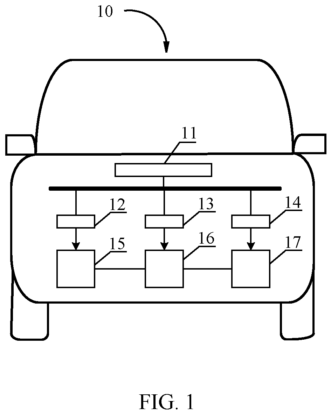

Refer to FIG. 1, which is a schematic structural diagram of a vehicle provided in some embodiments of this application. The vehicle can be a fuel car, a gas car, or a new energy vehicle. New energy vehicles can be battery electric vehicles, hybrid vehicles, or extended-range vehicles, or the like. The interior of the vehicle is equipped with a vehicle controller 11, a high-voltage battery control unit 12, a logic control unit 13 for a bidirectional DC/DC module, a low-voltage battery control unit 14, a high-voltage battery 15, a bidirectional DC/DC module 16, and a low-voltage battery 17. Among them, the bidirectional DC/DC module 16 is connected between the high-voltage battery 15 and the low-voltage battery 17 to realize charging and discharging processes between the high-voltage battery 15 and the low-voltage battery 17.

Among them, both the high-voltage battery 15 and the low-voltage battery 17 include at least one cell, which is used for being charged or discharged, and can be recharged in a recyclable manner. The high-voltage battery 15 typically refers to a battery that can provide a voltage above 48V, and the low-voltage battery 17 typically refers to a battery that can provide a voltage within 48V (including 48V). The high-voltage battery 15 can be configured to supply power to high-voltage loads in the vehicle, and the low-voltage battery 17 can be configured to supply power to low-voltage loads in the vehicle. For example, the high-voltage battery 15 can serve as a power source for the vehicle's air conditioning, and the low-voltage battery 17 can serve as a power source for the vehicle's indicator lights.

The vehicle controller 11 is connected to the high-voltage battery control unit 12, the logic control unit 13 for the bidirectional DC/DC module, and the low-voltage battery control unit 14 via communication lines. The vehicle controller 11 can issue operation commands to the high-voltage battery control unit 12, the logic control unit 13 for the bidirectional DC/DC module, and the low-voltage battery control unit 14, or receive instructions input by the high-voltage battery control unit 12, the logic control unit 13 for the bidirectional DC/DC module, and the low-voltage battery control unit 14. The high-voltage battery control unit 12 is configured to control the charging and discharging process of the high-voltage battery 15. The low-voltage battery control unit 14 is configured to control the charging and discharging process of the low-voltage battery 17. The logic control unit 13 for the bidirectional DC/DC module is configured to control the bidirectional DC/DC module 16, so that the high-voltage battery 15 charges the low-voltage battery 17, or the low-voltage battery 17 charges the high-voltage battery 15.

It should be noted that FIG. 1 is only for illustrative purposes regarding the high-voltage battery 15 and the low-voltage battery 17. In other embodiments, the high-voltage battery 15 and the low-voltage battery 17 can alternatively include more or fewer components, or have different component configurations, which are not limited by the embodiments of this application. For example, the high-voltage battery 15 and the low-voltage battery 17 in the embodiments of this application can be lithium-ion batteries, lithium metal batteries, lead-acid batteries, nickelcadmium batteries, nickel-metal hydride batteries, lithium-sulfur batteries, lithium-air batteries, sodium-ion batteries, or the like, without limitation. In terms of scale, the high-voltage battery 15 and the low-voltage battery 17 in the embodiments of this application can be a single cell, or a battery module composed of multiple cells connected in series and/or parallel, or a battery pack composed of multiple battery modules connected in series and/or parallel, or a power supply device composed of multiple battery packs connected in parallel, without limitation. In terms of application scenarios, the high-voltage battery 15 and the low-voltage battery 17 can be used within motive devices such as automobiles and ships. For example, they can be applied to motive vehicles to supply power to the electric motors of motive vehicles, serving as the traction source for electric vehicles. The battery can also supply power to other electrical devices in electric vehicles, such as supplying power to the vehicle air conditioning and vehicle players.

Moreover, the hardware structure of the electric vehicle 10 as shown in FIG. 1 is only an example, and the electric vehicle 10 can have more or fewer components than shown, can combine two or more components, or can have different component configurations. The various components shown can be implemented in hardware, software, or a combination of hardware and software, including one or more signal processing and/or specialized integrated circuits.

For example, in one embodiment, the low-voltage battery control unit 14 and the logic control unit 13 for the bidirectional DC/DC module can be integrated, and furthermore, integrated into the vehicle controller 11. This means the charging and discharging process of the high-voltage battery 15 is controlled by the vehicle controller 11. For another example, in another embodiment, the logic control unit 13 for the bidirectional DC/DC module and the low-voltage battery control unit 14 can both be integrated into the vehicle controller 11, while the charging and discharging process of the high-voltage battery 15 is still controlled by the high-voltage battery control unit 12. For yet another example, in yet another embodiment, the high-voltage battery control unit 12, the logic control unit 13 for the bidirectional DC/DC module, and the low-voltage battery control unit 14 can all be integrated into the vehicle controller 11, at which point, the vehicle controller 11, the high-voltage battery control unit 12, the logic control unit 13 for the bidirectional DC/DC module, and the low-voltage battery control unit 14 can be collectively referred to as a main control unit. This main control unit can perform the functions of the vehicle controller 11, the high-voltage battery control unit 12, the logic control unit 13 for the bidirectional DC/DC module, and the low-voltage battery control unit 14, to calibrate the state of the low-voltage battery 17, that is, to calibrate the state of health value of the low-voltage battery 17.

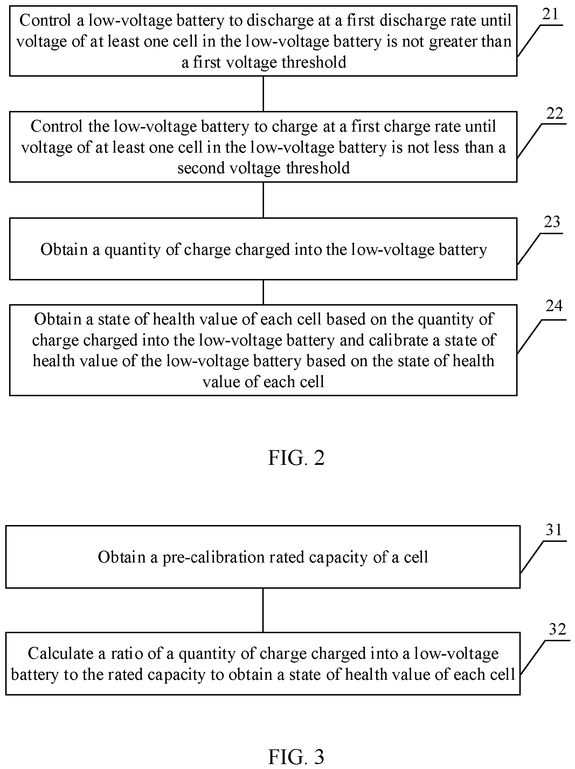

Refer to FIG. 2, which is a flowchart of a state calibration method for a low-voltage battery provided in an embodiment of this application. The state calibration method for a low-voltage battery includes the following steps:

Step 21: Control the low-voltage battery to discharge at a first discharge rate until voltage of at least one cell in the low-voltage battery is not greater than a first voltage threshold.

The low-voltage battery includes at least one cell.

The first discharge rate is a pre-set discharge rate, and the first voltage threshold is a pre-set voltage value. The specific values of the first discharge rate and the first voltage threshold can be set according to actual application situations, and embodiments of this application do not specifically limit them.

For example, in one embodiment, the first discharge rate can be set to any value in (0.05C, 10C), where C represents a rate indicating the current intensity during battery charging and discharging. For a 1200mAh battery, 0.2C means the current during battery charging and discharging is 240mA (0.2 times 1200mAh), and 1C means the current during battery charging and discharging is 1200mA (1 times 1200mAh).

Similarly, in another embodiment, the first voltage threshold can be set to a cut-off voltage that the cell can discharge to. The cut-off voltage of a cell refers to a minimum voltage at which the cell does not experience over-discharge, that is, if the voltage of the cell is less than the cut-off voltage, it means that the cell has experienced over-discharge. Thus, this can also ensure that the low-voltage battery does not experience over-discharge during the discharge process, protecting the low-voltage battery and extending the service life of the low-voltage battery.

In one embodiment, before step 21, the state calibration method for a low-voltage battery further includes: in an event that the electric vehicle is in an idle condition, obtaining a second duration based on an SOC value of the low-voltage battery.

The second duration is a duration for calibrating the state of the low-voltage battery. The SOC value is a ratio of the remaining quantity of charge of the battery to the nominal capacity of the battery. Persons skilled in the art can understand that the SOC (state of charge, state of charge) value of the battery can be a ratio of the battery's charge remaining to the battery's nominal capacity, or a ratio of the battery's charge remaining to the battery's current nominal capacity. The battery's nominal capacity can be a preset fixed value (for example, the value determined by the battery manufacturer when the battery leaves the factory), or the sum of the battery's charge remaining and the quantity of charge already discharged by the battery. The embodiments of this disclosure do not limit how the SOC of the battery is determined, and any existing or future implementations for determining the SOC of the battery can be applied to one or more embodiments provided by this disclosure.

Before calibration, it is first necessary to place the electric vehicle in an idle condition. The idle condition can be understood as a condition where the electric vehicle is not started, at which point, other than charging or discharging the battery during the calibration process, the battery is not in any use (for example, controlling the battery to supply power to the air conditioning in the electric vehicle). Thus, it can ensure that the low-voltage battery executes the state calibration process without interference from external conditions, enhancing the accuracy of calibration. Furthermore, after it is determined that the electric vehicle is in an idle condition, the duration required for the entire process of calibrating the state of the low-voltage battery can be determined based on the SOC value of the low-voltage battery, better managing the subsequent calibration process.

In one embodiment, after the obtaining a second duration, the method further includes: displaying the second duration through the electric vehicle.

With the second duration displayed through the electric vehicle, a reminder can be provided to a user of the electric vehicle. For one, the likelihood of the user mistakenly starting the electric vehicle and causing the calibration process to fail or the calibration results to be inaccurate can be reduced, during the state calibration process of the low-voltage battery. For another, after being informed of the time required for the state calibration of the low-voltage battery, the user can arrange the use and calibration time of the electric vehicle according to the user's actual situation, bringing convenience to the user and enhancing user experience.

In another embodiment, after the obtaining a second duration, the method further includes: on an occasion that the second duration is not displayed through the electric vehicle, determining calibration of the low-voltage battery as a failure in an event that the calibration of the low-voltage battery is not completed within the second duration.

In this embodiment, the electric vehicle does not display the second duration, but autonomously completes the state calibration process of the low-voltage battery. In this case, the calibration process of the low-voltage battery should be completed within the second duration to ensure the accuracy of the calibration results. However, if the calibration of the low-voltage battery is not completed within the second duration due to abnormal situations such as the user starting the vehicle, then the calibration of the low-voltage battery should be determined as a failure, reducing the likelihood of mis-calibration and thus making the calibration results more reliable.

Furthermore, in one embodiment, the electric vehicle can autonomously perform the state calibration process of the low-voltage battery after a fixed interval. For example, in one embodiment, the state calibration of the low-voltage battery can be set as a standard inspection item when the electric vehicle undergoes annual inspection, that is, the state calibration of the low-voltage battery is automatically initiated at the time. Similarly, in another embodiment, if no state calibration of the low-voltage battery has been performed for a preset duration, the calibration condition can be automatically triggered during long periods of vehicle idling or system upgrades of the vehicle to perform the state calibration process of the low-voltage battery. Thus, the SOH value obtained can be better assured with a small deviation from the actual SOH value, benefiting the full utilization of the low-voltage battery's performance. Moreover, the protective effect on the low-voltage battery is also better, further extending the battery's service life.

In one embodiment, the electric vehicle further includes a high-voltage battery, a bidirectional DC/DC module, and a low-voltage load, where the high-voltage battery is connected to the low-voltage battery through the bidirectional DC/DC module, and the low-voltage battery is connected to the low-voltage load. For the structure of the electric vehicle, reference can be made to the specific description for FIG. 1, and details are not repeated herein.

In this embodiment, the specific process of controlling the low-voltage battery to discharge at a first discharge rate in step 21 includes: controlling the bidirectional DC/DC module to control the low-voltage battery to discharge to the high-voltage battery at the first discharge rate.

Specifically, in one embodiment, the bidirectional DC/DC module is equipped with a plurality of switches, and the switches in the bidirectional DC/DC module can be controlled to turn on or off to enable current flow from the low-voltage battery to the high-voltage battery, thus implementing the process of the low-voltage battery discharging to the high-voltage battery. Furthermore, in one embodiment, the switching frequency of the switches in the bidirectional DC/DC module can be controlled to make the discharge rate of the low-voltage battery to the high-voltage battery the first discharge rate.

In this embodiment, through use of the bidirectional DC/DC module, charging and discharging processes can be realized between the high-voltage battery and the low-voltage batter. Then, conditions can be created for the full charging and full discharging of the low-voltage battery. If the state of the low-voltage battery is adjusted during full charging and full discharging of the low-voltage battery, a more accurate SOH value can be obtained, which is beneficial for providing more energy to the low-voltage load through the low-voltage battery.

It can be understood that the voltage of at least one cell in the low-voltage battery not being greater than the first voltage threshold can mean that only one cell in the voltage battery has discharged to less than or equal to the first voltage threshold, or a plurality of cells have simultaneously discharged to less than or equal to the first voltage threshold, which is not specifically limited by the embodiments of this application.

Step 22: Control the low-voltage battery to charge at a first charge rate until voltage of at least one cell in the low-voltage battery is not less than a second voltage threshold.

The first charge rate is a pre-set discharge rate, and the second voltage threshold is a pre-set voltage value. The specific values of the first charge rate and the second voltage threshold can be set according to actual application situations, and embodiments of this application do not specifically limit them. Furthermore, the first charge rate can be the same as or different from the first discharge rate.

In one embodiment, the second voltage threshold can be set to a maximum voltage that the cell can be charged to. The maximum voltage of a cell refers to the maximum voltage at which the cell does not experience overcharging, that is, if the voltage of the cell exceeds this maximum voltage, it means that the cell has experienced overcharging. In this case, in combination with the embodiment mentioned above, the first voltage threshold is set to the cut-off voltage that the cell can discharge to, and the second voltage threshold is set to the maximum voltage that the cell can be charged to, and thus full charging and full discharging of the cell can be realized. The state of the low-voltage lithium battery pack being calibrated during this process, the calibrated low-voltage battery can provide more energy to the low-voltage load.

In one embodiment, before step 22, the state calibration method for a low-voltage battery further includes: within a first duration, controlling the low-voltage battery to be in an idle state.

Specifically, after the voltage of at least one cell in the low-voltage battery is not greater than the first voltage threshold, the low-voltage battery stops discharging and the low-voltage battery is controlled to be in an idle state for a duration. With the low-voltage battery placed in an idle state, the polarization phenomenon of the low-voltage battery can be eliminated, stabilizing the state of the low-voltage battery. Thus, more reliable data can be obtained, which is beneficial for improving the accuracy of calculating the battery's state of health value.

In one embodiment, the duration for which the low-voltage battery is controlled to be in an idle state can be set to any duration in (0.1h, 10h), for example, 0.2h, that is, 0.2 hours. Of course, in other embodiments, the duration for which the low-voltage battery is controlled to be in an idle state can be set according to actual application situations, as long as it facilitates the elimination of the polarization phenomenon of the low-voltage battery, which is not specifically limited by the embodiments of this application.

Similarly, it can be understood that the voltage of at least one cell in the low-voltage battery not being less than the second voltage threshold can mean that only one cell in the voltage battery has been charged to greater than or equal to the second voltage threshold, or a plurality of cells have simultaneously been charged to greater than or equal to the second voltage threshold, which is not specifically limited by the embodiments of this application.

Step 23: Obtain a quantity of charge charged into the low-voltage battery.

The quantity of charge charged into the low-voltage battery can be obtained through the ampere-hour integration method. Specifically, the quantity of charge Q

$$Q = \int_{t0}^{t} I \cdot d_\tau$$

charged into the low-voltage battery is: .

Here, I is the discharge current, t can be the moment when discharging ends, t0 is the moment when discharging starts, and $d_\tau$ represents integration over time. By calculating the integration in the above formula, the quantity of charge Q charged into the low-voltage battery can be obtained.

Step 24: Obtain a state of health value of each cell based on the quantity of charge charged into the low-voltage battery and calibrate a state of health value of the low-voltage battery based on the state of health value of each cell.

In one embodiment, as shown in FIG. 3, the process of obtaining a state of health value of each cell based on the quantity of charge charged into the low-voltage battery in step 24 includes the following steps:

> Step 31: Obtain a pre-calibration rated capacity of the cell.
> Step 32: Calculate a ratio of the quantity of charge charged into the low-voltage battery to the rated capacity to obtain the state of health value of each cell.

The pre-calibration rated capacity of the cell refers to the rated capacity of each cell before execution of the state calibration method for a low-voltage battery. During use of the battery, cells usually gradually age, leading to a gradual decline in their rated capacity. Through obtaining of the pre-calibration rated capacity of the cell, the actual state of the cell can be better reflected, benefiting the accuracy of subsequent state calibration of the low-voltage battery.

Then, the state of health value of each cell can be calculated. The specific calculation method is to take the ratio of the quantity of charge Q charged into the low-voltage battery to the pre-calibration rated capacity Q1 of the cell, that is, Q/Q1, as the state of health value of each cell.

In this embodiment, through obtaining of the state of health value of each cell, the overall actual state of health value of the battery can be more accurately reflected, making a small deviation between the calculated state of health value of the battery and the actual state of health value of the battery, thus obtaining a comparatively accurate state of health value.

In one embodiment, the process of calibrating a state of health value of the low-voltage battery based on the state of health value of each cell in step 24 includes:

taking a smallest value among the state of health value of each cell as a current state of health value of the low-voltage battery.

Specifically, after the state of health value of each cell is obtained, the state of health values of the cells are subjected to a pairwise comparison to determine a cell with the smallest state of health value in the battery. It can be understood that the cell with the smallest state of health value can be only one or a plurality (the plurality of cells have equal states which are of the smallest value), which is not specifically limited by the embodiments of this application.

In this embodiment, with the smallest value taken as the current state of health value of the low-voltage battery, it can be ensured that there is enough energy available for release. In other words, this can increase the usable capacity of the battery, making full use of the battery's performance. Furthermore, it also ensures a certain residual capacity to prevent the battery from over-discharging, thus protecting the battery and extending its service life.

It should be noted that in this embodiment, taking the smallest value as the current state of health value of the low-voltage battery is only an example. In other embodiments, after obtaining of the state of health value of each cell, state of health values of other cells can also be taken as the current state of health value of the low-voltage battery, which is not specifically limited by the embodiments of this application.

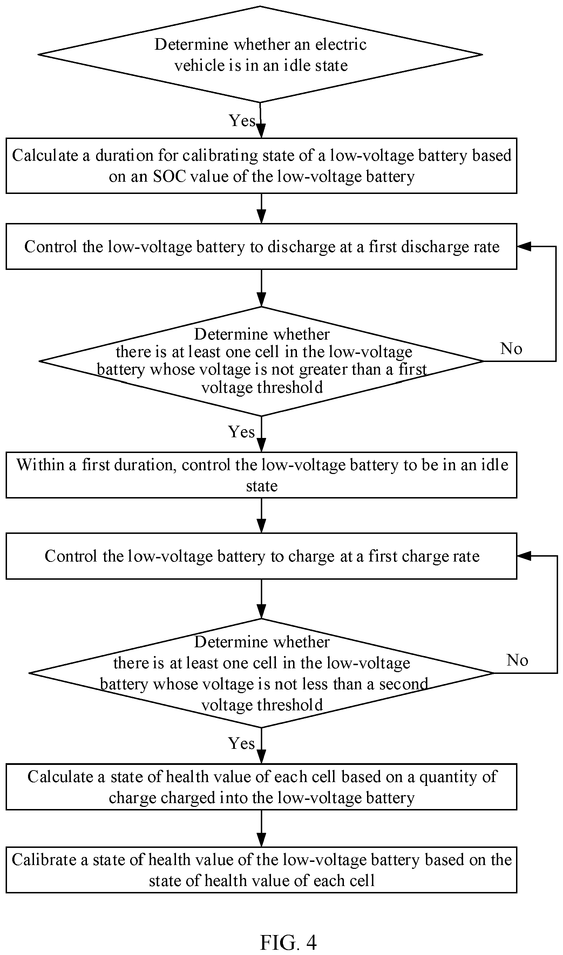

In one embodiment, refer to FIG. 4, which is a flowchart of a state calibration method for a low-voltage battery disclosed in another embodiment of this application. For the structure of the electric vehicle, reference can be made to the specific description for FIG. 1, and details are not repeated herein.

As shown in FIG. 4, first, a vehicle controller in an electric vehicle determines whether the electric vehicle is in an idle state. If so, a low-voltage battery control unit can calculate a duration for calibrating the state of the low-voltage battery based on a current SOC value of the low-voltage battery, which is the second duration. Then, the low-voltage battery control unit can provide the second duration to a human-machine interface system, for example, displaying the second duration on a user's mobile phone, and requesting confirmation from the user. After confirmation is received from the human-machine interface system, the state calibration process for the low-voltage battery begins. Next, the low-voltage battery is controlled to discharge at a first discharge rate and it is continuously determined whether there is at least one cell in the low-voltage battery whose voltage is not greater than a first voltage threshold. If there is at least one cell whose voltage is greater than the first voltage threshold, the discharging stops, and the low-voltage battery is controlled to be in an idle state for a first duration. After the idle time ends, that is, after the first duration ends, the low-voltage battery is controlled to charge at a first charge rate and it is continuously determined whether there is at least one cell in the low-voltage battery whose voltage is not less than a second voltage threshold. If there is at least one cell whose voltage is not less than the second voltage threshold, a quantity of charge charged into the low-voltage battery is calculated, and based on the charged quantity, a state of health value of each cell is calculated. The state of health value of each cell is a ratio of the quantity of charge charged into the low-voltage battery to a pre-calibration rated capacity of the cell. Then, based on the state of health value of each cell, a state of health value of the low-voltage battery is calibrated, where specifically, a smallest value among the state of health value of each cell is taken as a current state of health value of the low-voltage battery. Thus, the state calibration process for the low-voltage battery is completed.

In this embodiment, through controlling of the charging and discharging process of the low-voltage battery, the SOH value of each cell can be obtained based on the quantity of charge charged, and the current SOH value of the low-voltage battery can be finally determined based on the SOH value of each cell, thus obtaining a comparatively accurate SOH value. Additionally, with the first and second voltage thresholds specified, full charging and full discharging of cells can be realized. If the SOH value of the low-voltage battery is calibrated during this process, a more accurate SOH value can be obtained, which is beneficial for providing more energy to the low-voltage load through the low-voltage battery. Moreover, after a more accurate SOH value is obtained, the power output of the low-voltage battery can be controlled more accurately, effectively reducing the risk of battery damage, which is beneficial for improving the stability of battery performance and extending the battery's service life.

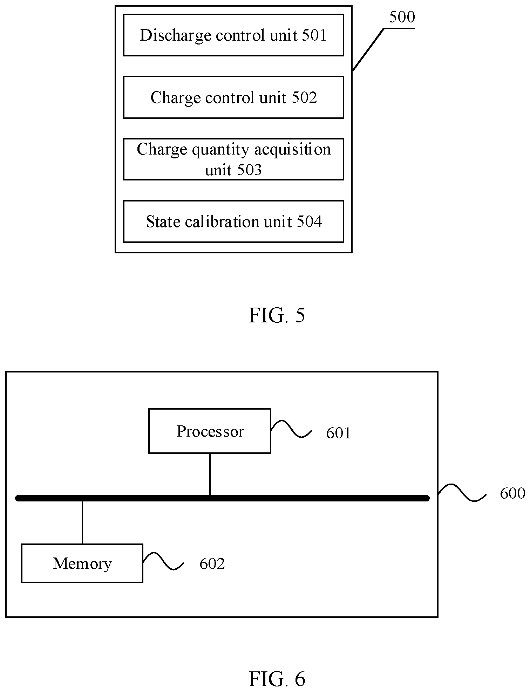

Refer to FIG. 5, which is a schematic structural diagram of a state calibration apparatus for a low-voltage battery disclosed in an embodiment of this application, where the low-voltage battery includes at least one cell. The state calibration apparatus 500 for a low-voltage battery includes: a discharge control unit 501, a charge control unit 502, a charge quantity acquisition unit 503, and a state calibration unit 504.

The discharge control unit 501 is configured to control the low-voltage battery to discharge at a first discharge rate until voltage of at least one cell in the low-voltage battery is not greater than a first voltage threshold.

The charge control unit 502 is configured to control the low-voltage battery to charge at a first charge rate until voltage of at least one cell in the low-voltage battery is not less than a second voltage threshold.

The charge quantity acquisition unit 503 is configured to obtain a quantity of charge charged into the low-voltage battery.

The state calibration unit 504 is configured to obtain a state of health value of each cell based on the quantity of charge charged into the low-voltage battery and calibrate a state of health value of the low-voltage battery based on the state of health value of each cell.

The above product can execute the method provided in the embodiments of this application shown in FIG. 2, possessing the corresponding functional modules to execute the method and the corresponding beneficial effects. For technical details not described in detail in this embodiment, reference can be made to the method provided in the embodiments of this application.

Refer to FIG. 6, which is a schematic structural diagram of a main control unit disclosed in an embodiment of this application. As shown in FIG. 6, the main control unit 600 includes one or more processors 601 and a memory 602. Here in FIG. 6, one processor 601 is shown as an example.

The processor 601 and the memory 602 can be connected via a bus or other means, with a bus connection shown in FIG. 6 as an example.

The memory 602, as a non-volatile computer-readable storage medium, can be configured to store non-volatile software programs, non-volatile computer executable programs, and modules, such as program instructions/modules corresponding to the state calibration method for a low-voltage battery as described in the embodiments of this application (for example, the units described in FIG. 5). The processor 601 executes various functional applications and data processing of the state calibration apparatus for a low-voltage battery by running the non-volatile software programs, instructions, and modules stored in the memory 602, that is, implementing the state calibration method for a low-voltage battery in the method embodiments described above and the functions of the various units in the apparatus embodiments.

The memory 602 can include a high-speed random-access memory and may also include a non-volatile memory, such as at least one magnetic disk storage device, flash storage device, or other non-volatile solid-state storage device. In some embodiments, the memory 602 may optionally include a memory remotely disposed relative to the processor 601, which can be connected to the processor 601 via a network. Examples of such networks include but are not limited to the Internet, intranets, local area networks, mobile communication networks, and their combinations.

The program instructions/modules stored in the memory 602, when executed by the one or more processors 601, execute the state calibration method for a low-voltage battery as described in any embodiment of the method above, for example, executing the various steps shown in FIGs. 2, 3, and 4; or implementing the functions of the various units described in FIG. 5.

This application also provides an electric vehicle including a low-voltage battery and the main control unit as described in any embodiment above.

For the structure of the electric vehicle, reference can be made to the specific description for FIG. 1 and details are not repeated herein.

This application also provides a non-volatile computer storage medium, where the computer storage medium stores computer executable instructions, and computer executable instructions, when executed by one or more processors, enable the one or more processors to execute the state calibration method for a low-voltage battery as described in any embodiment of the method above, for example, executing the various steps described above shown in FIGs. 2, 3, and 4; or implementing the functions of the various units described in FIG. 5.

The apparatus or device embodiments described above are merely illustrative, where the units described as separate components may be or may not be physically separate, the components shown as units may be or may not be physical units, that is, they may be located in one place or distributed on multiple network units. Some or all of the modules can be selected according to actual needs to achieve the purpose of the solution of this embodiment.

Through the description of the above embodiments, persons skilled in the art can clearly understand that the embodiments can be implemented by software plus a general hardware platform, or certainly be implemented by hardware. Based on such an understanding, the technical solutions essentially or the part contributing to the prior art can be embodied in the form of a software product. This computer software product can be stored in a computer-readable storage medium, such as a ROM/RAM, magnetic disk, or optical disc, including several instructions for enabling a computer device (which may be a personal computer, a server, or a network device) to execute the method according to the embodiments of this application or some parts thereof.

Although this application has been described with some preferred embodiments, various improvements and equivalent substitutions can be made without departing from the scope of this application. In particular, the various technical features mentioned in the embodiments can be combined in any forms at the absence of structural conflicts. This application is not limited to the specific embodiments disclosed herein but includes all technical solutions falling within the scope of the claims.

**Claims**

1.  A state calibration method for a low-voltage battery, wherein the low-voltage battery comprises at least one cell, the method comprising:

    controlling the low-voltage battery to discharge at a first discharge rate until voltage of at least one cell in the low-voltage battery is not greater than a first voltage threshold;
    controlling the low-voltage battery to charge at a first charge rate until voltage of at least one cell in the low-voltage battery is not less than a second voltage threshold;

obtaining a quantity of charge charged into the low-voltage battery; and

obtaining a state of health value of each cell based on the quantity of charge charged into the low-voltage battery and calibrating a state of health value of the low-voltage battery based on the state of health value of each cell.

2. The method according to claim 1, wherein before the controlling the low-voltage battery to charge at a first discharge rate, the method further comprises:
within a first duration, controlling the low-voltage battery to be in an idle state.

3. The method according to claim 1, wherein the obtaining a state of health value of each cell based on the quantity of charge charged into the low-voltage battery comprises:

obtaining a pre-calibration rated capacity of the cell; and

calculating a ratio of the quantity of charge charged into the low-voltage battery to the rated capacity to obtain the state of health value of each cell.

4. The method according to claim 3, wherein the calibrating a state of health value of the low-voltage battery based on the state of health value of each cell comprises:
taking a smallest value among the state of health value of each cell as a current state of health value of the low-voltage battery.

5. The method according to claim 1, wherein the low-voltage battery is provided in an electric vehicle, and before the controlling the low-voltage battery to discharge at a first discharge rate, the method further comprises:

in an event that the electric vehicle is in an idle condition, obtaining a second duration based on an SOC value of the low-voltage battery;

wherein the second duration is a duration for calibrating the state of the low-voltage battery.

6. The method according to claim 5, further comprising:
displaying the second duration through the electric vehicle.

7. The method according to claim 5, further comprising:
on an occasion that the second duration is not displayed through the electric vehicle, determining calibration of the low-voltage battery as a failure in an event that the calibration of the low-voltage battery is not completed within the second duration.

8. The method according to claim 5, wherein the electric vehicle further comprises a high-voltage battery, a bidirectional DC/DC module, and a low-voltage load, wherein the high-voltage battery is connected to the low-voltage battery through the bidirectional DC/DC module, and the low-voltage battery is connected to the low-voltage load; and
the controlling the low-voltage battery to discharge at a first discharge rate comprises:
controlling the bidirectional DC/DC module to control the low-voltage battery to discharge to the high-voltage battery at the first discharge rate.

9. The method according to claim 8, wherein the controlling the low-voltage battery to charge at a first charge rate comprises:
controlling the bidirectional DC/DC module to control the high-voltage battery to charge the low-voltage battery at the first charge rate.

10. A state calibration apparatus for a low-voltage battery, wherein the low-voltage battery comprises at least one cell, the apparatus comprising:

a discharge control unit configured to control the low-voltage battery to discharge at a first discharge rate until voltage of at least one cell in the low-voltage battery is not greater than a first voltage threshold;

a charge control unit configured to control the low-voltage battery to charge at a first charge rate until voltage of at least one cell in the low-voltage battery is not less than a second voltage threshold;

a charge quantity acquisition unit configured to obtain a quantity of charge charged into the low-voltage battery; and

a state calibration unit configured to obtain a state of health value of each cell based on the quantity of charge charged into the low-voltage battery and calibrate a state of health value of the low-voltage battery based on the state of health value of each cell.

11. A main control unit comprising:

a memory; and

a processor coupled to the memory, wherein the processor is configured to execute instructions stored in the memory to perform the method according to any one of claims 1 to 9.

12. An electric vehicle comprising: a low-voltage battery and the main control unit according to claim 11, wherein the main control unit is configured to calibrate state of the low-voltage battery.

13. The electric vehicle according to claim 12, wherein the electric vehicle further comprises a high-voltage battery and a bidirectional DC/DC module;

the high-voltage battery is connected to the low-voltage battery through the bidirectional DC/DC module, and the bidirectional DC/DC module is connected to the main control unit; the main control unit is configured to control the bidirectional DC/DC module, so that the high-voltage battery charges the low-voltage battery, or the low-voltage battery charges the high-voltage battery.

14. The main control unit according to claim 13, wherein the main control unit comprises a vehicle controller, a low-voltage battery control unit, a logic control unit for the bidirectional DC/DC module, and a high-voltage battery control unit; wherein
the vehicle controller is configured to control the low-voltage battery control unit, the logic control unit for the bidirectional DC/DC module, and the high-voltage battery control unit; the low-voltage battery control unit is configured to control charging and discharging of the low-voltage battery; the logic control unit for the bidirectional DC/DC module is configured to control the bidirectional DC/DC module; and the high-voltage battery control unit is configured to control charging and discharging of the high-voltage battery.

15. A computer-readable storage medium storing computer-executable instructions, wherein the computer-executable instructions are programmed as a process of the method according to any one of claims 1 to 9.

FIG. 1

Control a low-voltage battery to discharge at a first discharge rate until voltage of at least one cell in the low-voltage battery is not greater than a first voltage threshold ____ 21

Control the low-voltage battery to charge at a first charge rate until voltage of at least one cell in the low-voltage battery is not less than a second voltage threshold ____ 22

Obtain a quantity of charge charged into the low-voltage battery ____ 23

Obtain a state of health value of each cell based on the quantity of charge charged into the low-voltage battery and calibrate a state of health value of the low-voltage battery based on the state of health value of each cell ____ 24

FIG. 2

Obtain a pre-calibration rated capacity of a cell ____ 31

Calculate a ratio of a quantity of charge charged into a low-voltage battery to the rated capacity to obtain a state of health value of each cell ____ 32

FIG. 3

Determine whether an electric
vehicle is in an idle state

Yes

Calculate a duration for calibrating state of a low-voltage battery based
on an SOC value of the low-voltage battery

Control the low-voltage battery to discharge at a first discharge rate

Determine whether
there is at least one cell in the low-voltage
battery whose voltage is not greater than a first
voltage threshold

No

Yes

Within a first duration, control the low-voltage battery to be in an idle
state

Control the low-voltage battery to charge at a first charge rate

Determine whether
there is at least one cell in the low-voltage
battery whose voltage is not less than a second
voltage threshold

No

Yes

Calculate a state of health value of each cell based on a quantity of
charge charged into the low-voltage battery

Calibrate a state of health value of the low-voltage battery based on the
state of health value of each cell

FIG. 4

Discharge control unit 501

500

Charge control unit 502

Charge quantity acquisition unit 503

State calibration unit 504

FIG. 5

Processor

601

600

Memory

602

FIG. 6

## INTERNATIONAL SEARCH REPORT

| | International application No. |
|---|---|
| | **PCT/CN2021/142096** |

**A.    CLASSIFICATION OF SUBJECT MATTER**

G01R 31/36(2019.01)i;  G01R 31/367(2019.01)i;  G01R 31/392(2019.01)i;  H01M 10/48(2006.01)i

According to International Patent Classification (IPC) or to both national classification and IPC

**B.    FIELDS SEARCHED**

Minimum documentation searched (classification system followed by classification symbols)

G01R; H01M

Documentation searched other than minimum documentation to the extent that such documents are included in the fields searched

Electronic data base consulted during the international search (name of data base and, where practicable, search terms used)

CNABS; CNTXT; CNKI; VEN; USTXT; WOTXT; EPTXT: 电池, 电芯, 健康, 校准, 矫正, 校正, 修正, 调整, 充电, 放电, 电量, 电荷, 电压, 精确, 精度, 准确, battery, SOH, state of health, calibrat+, adjust+, correct+, charg+, discharg+

**C.    DOCUMENTS CONSIDERED TO BE RELEVANT**

| Category* | Citation of document, with indication, where appropriate, of the relevant passages | Relevant to claim No. |
|---|---|---|
| Y | CN 110988690 A (NINGDE CONTEMPORARY AMPEREX TECHNOLOGY CO., LTD.) 10 April 2020 (2020-04-10) description, paragraphs [0004]-[0163], and figures 1-14 | 1-15 |
| Y | EP 3276364 A1 (COMMISSARIAT À L'ENERGIE ATOMIQUE ET AUX ENERGIES ALTERNATIVES) 31 January 2018 (2018-01-31) description, paragraphs [0007]-[0038] | 1-15 |
| Y | CN 110967631 A (NINGDE CONTEMPORARY AMPEREX TECHNOLOGY CO., LTD.) 07 April 2020 (2020-04-07) description, paragraphs [0005]-[0146], and figures 1-10 | 1-15 |
| Y | CN 109507611 A (ANHUI JIANGHUAI AUTOMOBILE GROUP CO., LTD.) 22 March 2019 (2019-03-22) description, paragraphs [0004]-[0065] | 1-15 |
| Y | EP 3667345 A1 (COMMISSARIAT À L'ENERGIE ATOMIQUE ET AUX ENERGIES ALTERNATIVES) 17 June 2020 (2020-06-17) description, paragraphs [0007]-[0076] | 1-15 |

☑ Further documents are listed in the continuation of Box C.          ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **08 June 2022** | **24 June 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**EP 4 450 986 A1**

**INTERNATIONAL SEARCH REPORT**

| International application No. |
| PCT/CN2021/142096 |

### C. DOCUMENTS CONSIDERED TO BE RELEVANT

| Category* | Citation of document, with indication, where appropriate, of the relevant passages | Relevant to claim No. |
|---|---|---|
| Y | EP 3671243 A1 (COMMISSARIAT À L'ENERGIE ATOMIQUE ET AUX ENERGIES ALTERNATIVES) 24 June 2020 (2020-06-24) description, paragraphs [0007]-[0060] | 1-15 |
| Y | US 2014077764 A1 (BRUN-BUISSON DAVID et al.) 20 March 2014 (2014-03-20) description, paragraphs [0002]-[0050] | 1-15 |
| A | CN 102721926 A (AU OPTRONICS CORPORATION) 10 October 2012 (2012-10-10) entire document | 1-15 |

Form PCT/ISA/210 (second sheet) (January 2015)

**INTERNATIONAL SEARCH REPORT**
Information on patent family members

International application No.

**PCT/CN2021/142096**

| Patent document cited in search report | | | Publication date (day/month/year) | Patent family member(s) | | | Publication date (day/month/year) |
|---|---|---|---|---|---|---|---|
| CN | 110988690 | A | 10 April 2020 | US | 2021141028 | A1 | 13 May 2021 |
| | | | | EP | 3779484 | A1 | 17 February 2021 |
| | | | | WO | 2020216082 | A1 | 29 October 2020 |
| | | | | CN | 110988690 | B | 09 March 2021 |
| | | | | EP | 3779484 | A4 | 25 August 2021 |
| EP | 3276364 | A1 | 31 January 2018 | FR | 3054669 | A1 | 02 February 2018 |
| | | | | EP | 3276364 | B1 | 04 September 2019 |
| | | | | FR | 3054669 | B1 | 27 July 2018 |
| CN | 110967631 | A | 07 April 2020 | EP | 3786655 | A1 | 03 March 2021 |
| | | | | US | 2021116513 | A1 | 22 April 2021 |
| | | | | KR | 20210090687 | A | 20 July 2021 |
| | | | | JP | 2022511928 | A | 01 February 2022 |
| | | | | WO | 2020233326 | A1 | 26 November 2020 |
| | | | | CN | 110967631 | B | 30 March 2021 |
| | | | | US | 11047918 | B2 | 29 June 2021 |
| | | | | EP | 3786655 | A4 | 06 October 2021 |
| | | | | IN | 202117029136 | A | 03 December 2021 |
| CN | 109507611 | A | 22 March 2019 | CN | 109507611 | B | 28 July 2020 |
| EP | 3667345 | A1 | 17 June 2020 | FR | 3090115 | A1 | 19 June 2020 |
| | | | | FR | 3090115 | B1 | 25 December 2020 |
| | | | | EP | 667345 | B1 | 21 April 2021 |
| EP | 3671243 | A1 | 24 June 2020 | FR | 3090118 | A1 | 19 June 2020 |
| | | | | FR | 3090118 | B1 | 25 December 2020 |
| US | 2014077764 | A1 | 20 March 2014 | WO | 2012152770 | A2 | 15 November 2012 |
| | | | | EP | 2707935 | A2 | 19 March 2014 |
| | | | | FR | 2975238 | A1 | 16 November 2012 |
| | | | | US | 9472962 | B2 | 18 October 2016 |
| | | | | WO | 2012152770 | A9 | 24 January 2013 |
| | | | | FR | 2975238 | B1 | 10 June 2016 |
| | | | | EP | 2707935 | B1 | 08 June 2016 |
| | | | | WO | 2012152770 | A3 | 23 May 2013 |
| CN | 102721926 | A | 10 October 2012 | TW | 201337297 | A | 16 September 2013 |
| | | | | CN | 102721926 | B | 27 August 2014 |
| | | | | TW | I451111 | B | 01 September 2014 |

Form PCT/ISA/210 (patent family annex) (January 2015)